(19) Europäisches Patentamt
European Patent Office
Office européen des brevets

(11) **EP 2 154 619 A1**

(12) **EUROPEAN PATENT APPLICATION**

(43) Date of publication:
**17.02.2010 Bulletin 2010/07**

(51) Int Cl.:
***G06F 17/50*** *(2006.01)*

(21) Application number: **08014217.7**

(22) Date of filing: **08.08.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Austriamicrosystems AG**
**8141 Unterpremstätten (AT)**

(72) Inventor: **Senapati, Biswanath**
**8010 Graz (AT)**

(74) Representative: **Epping - Hermann - Fischer**
**Patentanwaltsgesellschaft mbH**
**Ridlerstrasse 55**
**80339 München (DE)**

(54) **Method for determining performance of a semiconductor device and method for determination of parameters of a semiconductor device**

(57)    A semiconductor junction comprised by a semiconductor device is represented as a parallel connection of a first and a second series connection (DF, DR), wherein the first series connection (DF) comprises a first current source (If) and a first resistor (Rf) and the second series connection (DR) comprises a second current source (Ir) and a second resistor (Rr). A first current of the first current source (If) is calculated depending on a junction voltage (Vd) across the semiconductor junction as a function of a first parameter set. A second current of the second current source (Ir) is calculated depending on the junction voltage (Vd) as a function of a second parameter set. A junction current over the semiconductor junction is calculated depending on the first and second current. Herein, the first and the second parameter set are selected such that the junction current is mainly determined by the first current, if the junction voltage (Vd) is a forward voltage, and the junction current is determined by the first and the second current if the junction voltage (Vd) is a reverse voltage.

Fig 2

## Description

The invention relates to a method for determining performance of a semiconductor device which comprises a semiconductor junction. The invention further relates to a method for determination of parameters of such a semiconductor device.

In the development of designing monolithic integrated circuits, a performance of the circuits is often determined or simulated numerically by representing respective elements of the circuits with specific parametric models. Furthermore, especially for monolithic integrated circuits, electrostatic discharge (ESD) protection circuits are often used. The ESD protection circuits are used to clamp an input voltage of the circuit which is to be protected below a breakdown voltage. For example, a critical voltage of the circuit is determined by a breakdown voltage of a gate oxide in a field-effect transistor comprised by the circuit. The ESD protection circuit usually comprises a discharging element like a transistor which can be triggered to a conductive state by a trigger device. In many cases, Zener diodes are used in reverse mode operation as trigger devices in ESD protection circuits.

In conventional ESD circuit design, designing is performed mainly based on measurements. However, these measurements are mostly destructive since the ESD target is to attain the voltage and the current limit before the device to be protected fails permanently.

In some cases, it has been tried to design ESD protection circuits based on a circuit simulation. However, the accuracy of the circuit simulation depends on the accuracy of parametric models used. Conventional models used in circuit simulators like SPICE or CADENCE SPECTRE are quite accurate in normal operating windows. For high-voltage ESD pulses, a diode model used for simulating Zener diodes may not match an electric behavior of a real Zener diode in reverse mode of operation of the diode. Therefore in some cases, effects at the semiconductor junction of a Zener diode cannot be simulated accurately under ESD conditions with conventional models.

It is therefore an object of the present invention to provide an improved method for representing a semiconductor junction for determining performance of a semiconductor device. It is a further object of the invention to provide a method for determination of parameters of a semiconductor device with improved accuracy.

The object is achieved with the subject matter of the independent patent claims. Embodiments and developments of the invention are subject matter of the dependent claims.

According to one embodiment, in a method for determining performance of a semiconductor device, wherein the semiconductor device comprises a semiconductor junction, the semiconductor junction is represented as a parallel connection of a first and a second series connection. The first series connection comprises a first current source and a first resistor and the second series connection comprises a second current source and a second resistor. A first current of the first current source is calculated depending on a junction voltage across the semiconductor junction as a function of a first parameter set. A second current of the second current source is calculated depending on the junction voltage as a function of a second parameter set. Depending on the first and the second current, a junction current over the semiconductor junction is calculated. Hereby, the first and the second parameter set are selected such that the junction current is mainly determined by the first current, if the junction voltage is a forward voltage, and the junction current is determined by the first and the second current, if the junction voltage is a reverse voltage.

The semiconductor device may be any kind of semiconductor diode having a PN semiconductor junction. The junction voltage is a forward voltage if a potential at the p-type area of the semiconductor junction is higher than a potential at an n-type area of the semiconductor junction. Accordingly, the junction voltage is a reverse voltage, if polarity at the PN junction is changed.

For a forward operation of the semiconductor device corresponding to a forward voltage at the semiconductor junction, a current over the semiconductor junction can be accurately calculated using the first current source. By providing the second current source for representing the semiconductor junction, it is possible to represent a reverse operation of the semiconductor device for normal operation conditions and higher reverse currents and reverse voltages, respectively, with a higher accuracy. To this end, respective parameter sets for the first and the second series connection are provided. Therefore, accuracy for determination or estimation of performance of a semiconductor device can be improved. Hence, a simulation of the semiconductor device can also be performed under ESD conditions.

The parameter sets can comprise different model parameters associated with a semiconductor junction. Some parameters may be used mainly for a forward operation of the semiconductor junction while other parameters can be used for a reverse operation of the semiconductor junction.

For example, for the junction voltage being a forward voltage, the first parameter set can comprise a first saturation current and a first emission coefficient which each are associated with the first current source. The first parameter set can further comprise a first resistance of the first resistor. Similarly, the second parameter set can comprise a second saturation current and a second emission coefficient which are associated with a second current source. Furthermore, a second resistance of the second resistor can be comprised by a second parameter set. Hence, calculation of the first and second current for a forward operation of the semiconductor junction can depend on these parameters.

For the junction voltage being a reverse voltage, the first parameter set can comprise a first reverse breakdown voltage, a first reverse current at the first reverse breakdown voltage and a first reverse breakdown voltage ideality factor which are each associated with the first current source. Furthermore, the second parameter set can comprise a second reverse breakdown voltage, a second reverse current at the second reverse breakdown voltage, and a second reverse breakdown voltage ideality factor, which are each associated with a second current source. These parameters can be used for calculating the first and the second current in a reverse operation of the semiconductor junction. For example, the first and the second breakdown voltage determine a respective breakthrough voltage from which on a reverse current over the semiconductor junction starts to rise significantly.

Parameter sets can comprise further parameters. For example, the first parameter set can comprise a first high-injection knee current and/or a first reverse high-injection knee current, which are each associated with the first current source. Accordingly, the second parameter set can comprise a second high-injection knee current and/or a second reverse high-injection knee current which are each associated with a second current source.

In one embodiment of the method, the semiconductor junction is further represented by a junction capacitance which is connected in parallel to the first current source. A capacitance value of the junction capacitance is dependent on the first parameter set and the junction voltage. Hereby, the junction current is further calculated depending on the value of the junction capacitance.

In this case, the first parameter set can comprise a zero bias junction capacitance, a junction potential, a grading coefficient, and a forward bias depletion capacitance coefficient which are each associated with the junction capacitance.

When calculating the junction current from the first and the second current, calculation is, for example, performed by summing up the first and the second current.

The meaning of the parameters described above is well-known in the art for semiconductor junctions and will therefore not be described in further detail.

Calculation of the first and the second current can be based on the same equations for first and second current source, respectively. However, the values of the first and the second parameter set can be different and chosen such that different effects of a real semiconductor junction can be modeled by first and second current which each cover respective voltage or current regions of the semiconductor junction. In other words, effects of the semiconductor junction not covered accurately by the first series connection can be compensated for by the second current through the second series connection, especially for higher reverse currents.

In an embodiment of a method for determination of parameters of a semiconductor device, the semiconductor device is provided comprising a semiconductor junction. A forward set of current-voltage pairs is measured with the semiconductor device, wherein a junction voltage across the semiconductor junction is a forward voltage. Accordingly, also a reverse set of current-voltage pairs is measured with the semiconductor device, wherein the junction voltage is a reverse voltage. The semiconductor junction is represented as a parallel connection of a first and a second series connection, wherein the first series connection comprises a first current source and a first resistor and the second series connection comprises a second current source and a second resistor. A first parameter set is associated with the first series connection and a second parameter set is associated with the second series connection. First parameters of the second parameter set which are associated with a forward operation of the second current source are set. From the forward set of current-voltage pairs, first parameters of the first parameter set which are associated with a forward operation of the first current source and with the first resistor are determined. From the reverse set of current-voltage pairs, second parameters of the first parameter set which are associated with a reverse operation of the first current source are determined. Furthermore, from the reverse set of current-voltage pairs, second parameters of the second parameter set which are associated with a reverse operation of the second current source and with the second resistor, are determined.

By the combination of setting and determining parameters for the first and the second series connection of the semiconductor junction model, both for a forward and a reverse operation of the semiconductor device, parameters can be found which make it possible to accurately represent a real voltage-current dependency of the semiconductor device by a respective parametric model depending on individual parameter sets.

For example, determining first parameters of the first parameter set comprises determining a first saturation current and a first emission coefficient, each associated with the first current source, and determining a first resistance of the first resistor.

Setting of first parameters of the second parameter set can comprise setting a second saturation current and a second emission coefficient, each associated with the second current source. By setting the first parameters of the second parameter set, it is possible to reduce the portion of the second current source with respect to a junction current in a forward mode of operation of the semiconductor device. Hence, a forward operation of the semiconductor junction can be mainly represented by the first parameters of the first parameter set. The setting can be performed as a function of a breakdown voltage of the semiconductor device which can be determined automatically from the reverse set of current-voltage pairs.

Determining of second parameters of the first parameter set can comprise determining a first reverse breakdown voltage, a first reverse current at the first reverse breakdown voltage, and a first reverse breakdown voltage ideality factor, which are each associated with the first current source. Hereby, determining of the first reverse breakdown voltage can comprise setting the first reverse breakdown voltage to a value being different from an actual breakdown voltage of the semiconductor device. Preferably the set first reverse breakdown voltage is greater than the actual breakdown voltage. By setting the first reverse breakdown voltage, it is made possible to represent a breakdown region of the semiconductor device mainly by the second parameters of the second parameter set.

For example, determining of second parameters of the second parameter set comprises determining a second reverse breakdown voltage, a second reverse current at the second reverse breakdown voltage and a second reverse breakdown voltage ideality factor, which are each associated with the second current source, and furthermore, determining a second resistance of the second resistor.

In one embodiment, determining of first parameters of the first parameter set further comprises determining a first high-injection knee current associated with the first current source. Determining of second parameters of the second parameter set can comprise determining a second reverse high-injection knee current associated with the second current source.

In one embodiment of the method for determination, the semiconductor device can further be represented by a junction capacitance connected in parallel to the first current source. In this case, a set of capacitance values can be measured for the semiconductor device depending on a voltage across the semiconductor junction. From the set of capacitance values, a zero bias junction capacitance, a junction potential, a grading coefficient, and a forward bias depletion capacitance coefficient can be determined.

The determination and/or setting of the above mentioned parameters can be performed automatically by a respective determination algorithm which preferably is implemented as a computer program. Manual input of additional values to such an algorithm is possible but not necessary.

The text below explains the invention in detail using exemplary embodiments with reference to the drawings, in which:

FIG. 1     is an exemplary embodiment of a circuit comprising an ESD protection circuit,

FIG. 2     is an embodiment of an equivalent circuit of a semiconductor device,

FIG. 3     is an embodiment of a flow chart for a determination of parameters of a semiconductor device,

FIG. 4     is a first voltage-current diagram,

FIG. 5     is a second voltage-current diagram,

FIG. 6     is a third voltage-current diagram,

FIG. 7     is a fourth voltage-current diagram, and

FIG. 8     is a voltage-capacitance diagram.

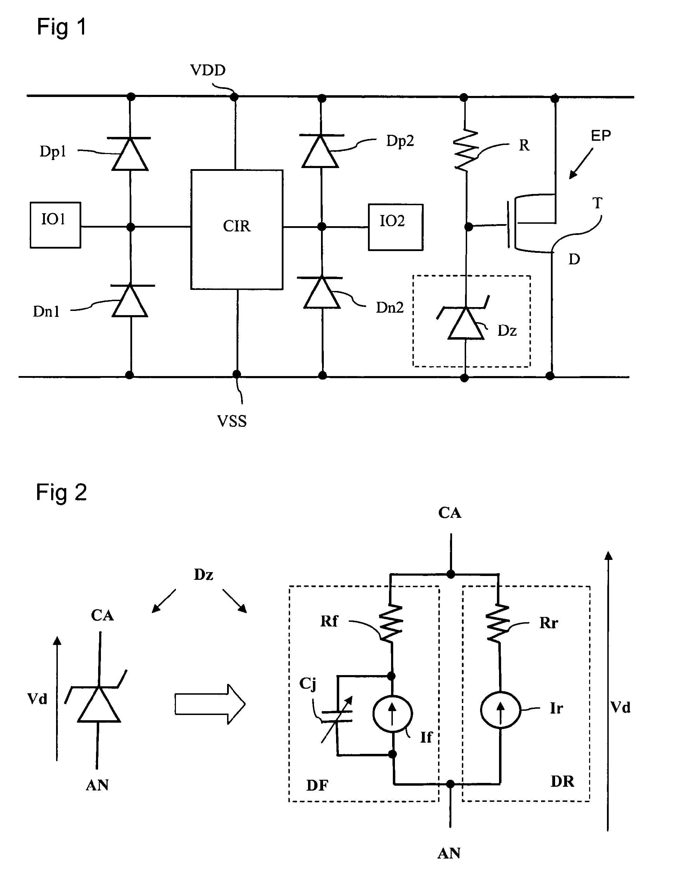

FIG. 1 shows a circuit diagram of an integrated circuit comprising an internal circuit CIR which is connected between supply voltage rails VDD, VSS. The internal circuit CIR is further connected to input/output ports IO1, IO2. The first input/output port IO1 is coupled to the positive supply voltage rail VDD via a diode Dp1, and to the negative supply voltage rail VSS via a diode Dn1. Similarly, the second input/output port IO2 is electrically coupled to the positive supply voltage rail VDD via a diode Dp2, and to the negative supply voltage rail VSS via a diode Dn2.

The circuit further comprises an ESD protection circuit EP comprising a resistor R, a discharging transistor T, and a Zener diode Dz. The Zener diode Dz and the resistor R are connected in series between the supply voltage rails VDD, VSS such that the Zener diode Dz is normally operated in a reverse mode of operation. Furthermore, a controlled connection of the transistor T is coupled between the supply voltage rails VDD, VSS. A control connection of transistor T is coupled to a connection of Zener diode Dz and resistor R.

The internal circuit CIR shown in FIG. 1 can be any kind of electronic circuit which may communicate with other circuits via input/output ports IO1, IO2. The diodes Dp1, Dp2, Dn1, Dn2 serve as a protection for the input/output ports IO1, IO2.

In case an ESD event occurs on the supply voltage rails VDD, VSS, an overvoltage can be deduced via transistor T. In this embodiment, the transistor T is shown as a field-effect transistor. However, in other embodiments, other discharging elements like bipolar transistors or thyristors can be used. The transistor T is switched to a conductive state depending on a voltage at its control input which is dependent on a current through the Zener diode Dz. In case of an ESD event, a breakthrough of the Zener diode Dz can occur resulting in a changed voltage potential at the control input of the transistor T. The changed voltage potential can act as a trigger for transistor T switching it to a conductive state. Therefore, an over-voltage resulting from the ESD event can be discharged via transistor T.

For a circuit design, it can be important to know or to predetermine, respectively, at which voltages at the ESD protection circuit ESD the transistor T is triggered. To this end, it can be tried to simulate or numerically calculate a respective trigger voltage of the ESD protection circuit EP.

In conventional simulation models or circuit simulation programs, diodes and especially Zener diodes are represented as a series connection of a resistor and a parallel connection of a current source and a capacitance.

A current through this equivalent model depending on a voltage Vd across the series connection can be calculated depending on various parameters. A set of these parameters, for example, comprises a saturation current IS and an emission coefficient N. A forward current corresponding to a positive voltage V at the semiconductor junction of the diode can be calculated by

$$I = IS\left(e^{\frac{V}{N \cdot V_T}} - 1\right) \quad \text{for} \quad V \le V_{FEXPL}, \qquad (1)$$

where $V_T$ is a thermal voltage given by

$$V_T = \frac{k \cdot T}{q} \qquad (2)$$

which is well-known in the art. In equation (1) $V_{FEXPL}$ is a forward explosion voltage at an explosion current imelt which can be determined by

$$V_{FEXPL} = N \cdot V_T \cdot \ln\left[1 + \frac{imelt}{IS}\right]. \qquad (3)$$

For a reverse operation of the diode corresponding to a negative voltage V across the semiconductor junction, a reverse current can be calculated. To this end, the parameter set further comprises a reverse breakdown voltage BV, a reverse current at the reverse breakdown voltage IBV and a reverse breakdown voltage ideality factor NZ. Accordingly, a reverse current is given by

$$I = -IBV \cdot e^{-\frac{V+BV}{NZ \cdot V_T}} \quad \text{for} \quad -(BV + V_{REXPL}) \le V, \qquad (4)$$

wherein $V_{REXPL}$ is a reverse explosion voltage given by

$$V_{REXPL} = NZ \cdot V_T \cdot \ln\left[1 + \frac{imelt}{IBV}\right]. \qquad (5)$$

The effects caused by the junction capacitance can be considered depending on a respective capacitance value $C_j$ which is dependent on the voltage V across the semiconductor junction and can be calculated according to

$$C_J(V) = \begin{cases} \dfrac{CJO}{\left(1 - \dfrac{V}{VJ}\right)^M} & ; V \leq FC * VJ \\[2em] \dfrac{CJO}{(1-FC)^M}\left[1 + \dfrac{M(V - VJ \cdot FC)}{VJ(1-FC)}\right] & ; V > FC * VJ \end{cases} \quad . \quad (6)$$

Herein CJO is a zero bias junction capacitance, VJ is a junction potential, M is a grading coefficient, and FC is a forward bias depletion capacitance threshold.

However, as this model is inaccurate, especially for voltages around the reverse breakdown voltage, an improved model for a Zener diode is presented.

FIG. 2 shows a Zener diode Dz having an anode AN and a cathode CA. The Zener diode Dz, which is shown as a circuit symbol on the left side of FIG. 2, is represented as an equivalent model comprising a first series connection DF and a second series connection DR. The first series connection DF comprises a first resistor Rf connected in series with a parallel connection of a capacitor Cj and a first current source If. The second series connection DR comprises a second resistor Rr and a second current source Ir. Vd indicates a junction voltage between anode AN and cathode CA.

A current through the Zener diode Dz therefore depends on a first current through the first current source If and a second current through the second current source Ir. Furthermore, a total junction current across the diode Dz depends on charging or discharging currents of the junction capacitance Cj.

The first and the second current through the first and the second current source If, Ir, respectively, can be calculated according to equations (1) and (4), wherein the first and second current source If, Ir each depend on an individual parameter set. Accordingly, a first parameter set for the first series connection DF comprises a first saturation current IS1, a first emission coefficient N1, which are associated with a forward operation of the first current source If. The first parameter set further comprises a first resistance RF1 of the first resistor Rf. For a reverse operation of the Zener diode Dz, the first parameter set further comprises a first reverse breakdown voltage BV1, a first reverse current IBV1 at the first reverse breakdown voltage BV1 and a first reverse breakdown voltage ideality factor NZ1, which are each associated with the first current source.

Similarly, a second parameter set for the second series connection DR comprises a second saturation current IS2 and a second emission coefficient N2, which are associated with a forward operation of the second current source Ir. The second parameter set further comprises a second resistance RS2 of the second resistor Rr. For a reverse operation of the Zener diode Dz, the second parameter set comprises a second reverse breakdown voltage BV2, a second reverse current IBV2 at the second reverse breakdown voltage BV2, and a second reverse breakdown voltage ideality factor NZ2, each being associated with the second current source Ir.

The first parameter set can further comprise parameters for the junction capacitance Cj as described above.

In some embodiments, the first and the second parameter set can further comprise a first and a second high-injection knee current IK1, IK2 and a first and a second reverse high-injection knee current IKR1, IKR2, which are each associated with the first and the second current source If, Ir, respectively. Use and application of the latter parameters are well-known in the art and will not be described further herein.

The parameters of the first and the second parameter set can be chosen or determined such that for a forward operation of the Zener diode Dz, a portion of the first current of the first current source If is dominant over the second current of the second current source Ir. In other words, the total junction current over the semiconductor device is mainly determined by the first series connection DF. However, for a reverse operation of the semiconductor device, both the first and the second currents of the first and the second current source If, Ir determine the total junction current, wherein the respective portion of the first and the second current with respect to the junction current depends on a respective voltage across the semiconductor junction of the Zener diode Dz. For example, in a low current leakage region of reverse current-voltage characteristics of the Zener diode Dz, the junction current is mainly determined by the first current source If, whereas for a breakdown region or avalanche region or for a high-current avalanche region of reverse current-voltage characteristics of the Zener diode Dz, the junction current is mainly determined by the second current source Ir or the second series connection DR, respectively.

The two series connections DF, DR make it possible to find a better matching between a calculated junction current and a real junction current over a Zener diode in a physical integrated circuit. Therefore, the performance of a semiconductor device like a Zener diode can be estimated or determined with a higher accuracy compared to conventional models of semiconductor junctions.

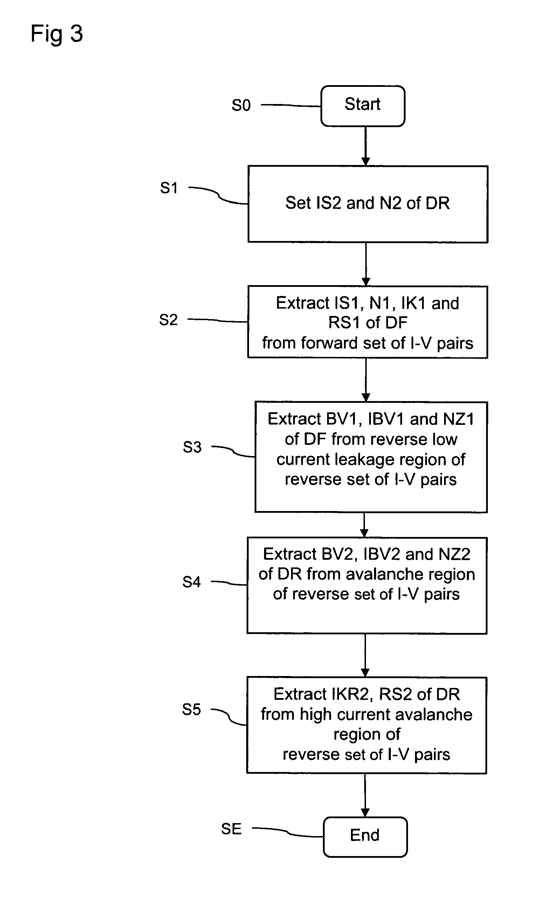

FIG. 3 shows an exemplary flow chart for determination of parameters of a semiconductor device which can, for example, be used in the equivalent circuit shown in FIG. 2 in combination with equations (1) to (6).

To this end, at S0, some preliminary steps are performed. For example, respective data sets for the semiconductor device are measured. This can include measuring a forward set of current-voltage pairs with the semiconductor device Dz, wherein a junction voltage Vd across the semiconductor junction of the semiconductor device is a positive voltage or forward voltage. Accordingly, also a reverse set of current-voltage pairs is measured with the semiconductor device, wherein the junction voltage Vd is a negative voltage or reverse voltage. Hence, both the measurement for forward operation of the semiconductor device and reverse operation are performed.

Furthermore, at S0, an equivalent circuit for the Zener diode Dz can be chosen, for example according to the circuit shown in FIG. 2.

At S1, first parameters of the second parameter set are set for the second saturation current IS2 and the second emission coefficient N2. For example, the second saturation current IS2 is set to a low value, preferably such low that for a forward operation of the second series connection DR, only a low second current can result. Furthermore, the second emission coefficient N2 is set to a value around 1, preferably exactly to 1. This setting can be performed with predetermined values.

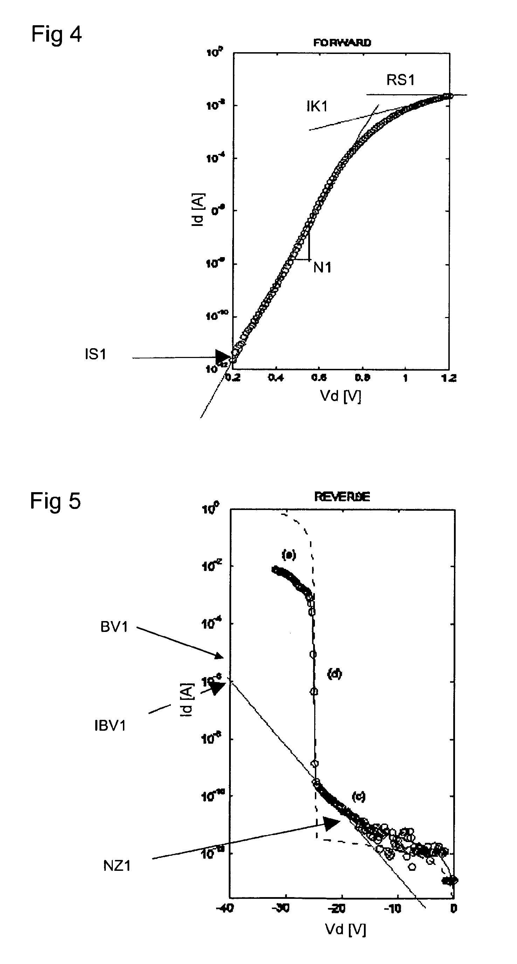

With reference to FIG. 4, which shows a forward set of current-voltage pairs of the semiconductor device Dz with a junction voltage Vd and a junction current Id, at S2, first parameters of the first parameter set are determined. For example, a first saturation current IS1 and a first emission coefficient N1 are determined from the forward set of current-voltage pairs. It should be noted that in FIG. 4 and also in FIGS. 5, 6 and 7, which will be described in more detail later, the measured current-voltage pairs are shown as small circles, whereas the characteristic calculated from extracted or determined parameters with the presented model is shown as a solid line. The parameters which can be determined from the set of current-voltage pairs can be extracted with well-known methods for parameter fitting or curve-fitting, respectively.

Further parameters from the first parameters of the first parameter set which can be extracted from the forward set of current-voltage pairs are a first high-injection knee current IK1 and the resistance RS1 of the first resistor Rf.

With reference to FIG. 5 which shows a reverse set of current-voltage pairs of the semiconductor device Dz, at S3, second parameters of the first parameter set corresponding to a reverse mode of operation are determined. The second parameters of the first parameter set, for example, comprise a first reverse breakdown voltage BV1, the first reverse current IBV1 at the first reverse breakdown voltage BV1 and the first reverse breakdown voltage ideality factor NZ1. Hereby, during extraction of the parameters, the first reverse breakdown voltage BV1 can be set to a value different from an actual breakdown voltage of the semiconductor device Dz. For example, the first reverse breakdown voltage BV1 is set to a value being absolutely higher than the actual breakdown voltage such that a breakdown region or avalanche region of the Zener diode Dz is not significantly determined by the first current source If. The actual breakdown voltage of the semiconductor device Dz can also be determined from the reverse set of current-voltage pairs.

It should be noted that a parameter extraction for the second parameters of the first parameter set is preferably performed with current-voltage pairs over a reverse low current leakage region. In other words, the parameters are extracted from current-voltage pairs where the voltage is lower than a breakdown voltage of the semiconductor device where no Zener effect or avalanche effect can be observed significantly.

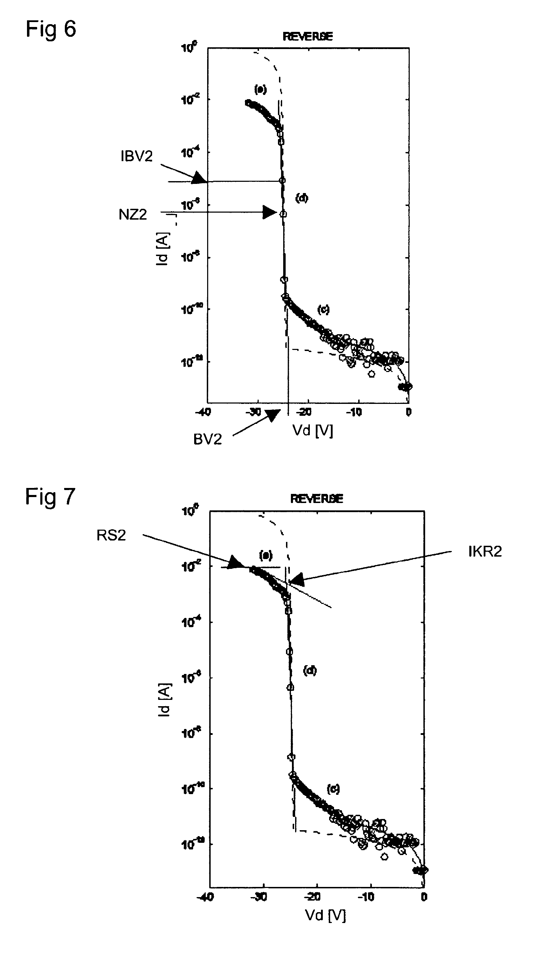

With reference to FIG. 6, which basically shows the same reverse set of current-voltage pairs as FIG. 5, at S4, second parameters of the second parameter set are extracted from an avalanche region of the reverse set of current-voltage pairs. The second parameters of the second parameter set comprise a second reverse breakdown voltage BV2, a second reverse current IBV2 at the second reverse breakdown voltage BV2, and a second reverse breakdown voltage ideality factor NZ2. These parameters which are associated with the second series connection DR therefore can be used to accurately calculate the junction current of the semiconductor device in the reverse avalanche region.

With reference to FIG. 7 showing the reverse set of current-voltage pairs, at S5, a second reverse high-injection knee current IKR2 and a second resistance RS2 of the second resistor Rr are extracted from a high current avalanche region of the reverse set of current-voltage pairs. Accordingly, a high-current region of the reverse mode of operation can be accurately modeled by the series resistance Rr of the second series connection DR and an extracted value of RS2 is usually significantly higher than a respective value RS1 of the first resistor Rf of the first series connection DF. As in a forward operation of the second series connection DR, only a small current is provided by the second current source Ir, the higher value of second resistor Rr does not significantly influence the behavior of the parametric model in a forward operation.

It can be seen, for example, from FIG. 7 that the proposed equivalent circuit using the parameters as explained, denoted by a solid line, matches the measured data set better than a conventional model which is shown as a dashed line.

The extraction of parameters ends at SE.

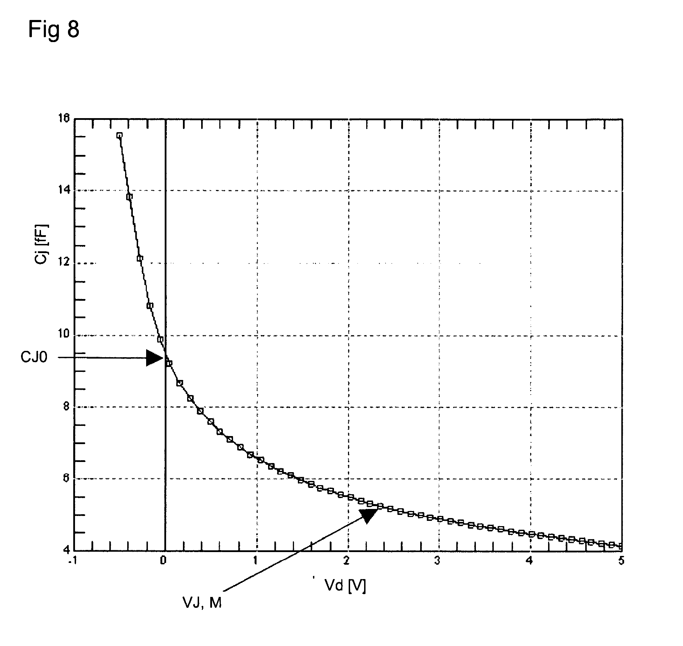

FIG. 8 shows a diagram of capacitance value of the junction capacitance of the semiconductor junction in dependency on a voltage across the semiconductor junction. From the respective measurement pairs shown as squares in FIG. 8, a zero bias junction capacitance CJO, a junction potential VJ, and a grading coefficient M which can be used in equation (6) can be extracted. Since this parameter determination is independent from the determination of the parameters of the current sources If, Ir and the resistors Rf, Rr, it can be performed, for example, at initial determination step S0 described above.

The extracted parameters described above can be used in a circuit simulator like SPICE or SPECTRE for determining performance of a Zener diode or electronic circuits comprising Zener diodes. However, as the model of the equivalent circuit shown in FIG. 2 is not limited to any simulation program, calculation of respective currents can be performed also in other ways which are apparent to a skilled person from this description.

Reference list

| | |
|---|---|
| VDD, VSS | supply voltage rail |
| CIR | internal circuit |
| IO1, IO2 | input/output port |
| R | resistor |
| T | transistor |
| Dp1, Dp2 | diode |
| Dn1, Dn2 | diode |
| Dz | Zener diode |
| DA | cathode |
| AN | anode |
| DF, DR | series connection |
| If, Ir | current source |
| Rf, Rr | resistor |
| Cj | junction capacitance |
| Vd | junction voltage |
| IS, IS1, IS2 | saturation current |
| N, N1, N2 | emission coefficient |
| RS, RS1, RS2 | resistance |
| IK, IK1, IK2 | high-injection knee current |
| BV, BV1, BV2 | reverse breakdown voltage |
| IBV, IBV1, IBV2 | reverse current at reverse breakdown voltage |
| NZ, NZ1, NZ2 | reverse breakdown ideality factor |
| IKR, IKR1, IKR2 | reverse high-injection knee current |
| CJ0 | zero bias junction capacitance |
| VJ | junction potential |
| M | grading coefficient |
| FC | forward bias depletion capacitance threshold |

**Claims**

1. Method for determining performance of a semiconductor device (Dz), the semiconductor device (Dz) comprising a semiconductor junction, the method comprising

   - representing the semiconductor junction as a parallel connection of a first and a second series connection (DF, DR), wherein the first series connection (DF) comprises a first current source (If) and a first resistor (Rf) and the second series connection (DR) comprises a second current source (Ir) and a second resistor (Rr);
   - calculating a first current of the first current source (If) depending on a junction voltage (Vd) across the semiconductor junction as a function of a first parameter set;
   - calculating a second current of the second current source (Ir) depending on the junction voltage (Vd) as a function of a second parameter set;
   - calculating a junction current over the semiconductor junction depending on the first and the second current;
   - wherein the first and the second parameter set are selected such that the junction current is mainly determined by the first current, if the junction voltage (Vd) is a forward voltage, and the junction current is determined by the first and the second current, if the junction voltage (Vd) is a reverse voltage.

2. Method according to claim 1, wherein, for the junction voltage (Vd) being a forward voltage,

- the first parameter set comprises a first saturation current and a first emission coefficient, each associated with the first current source (If), and a first resistance of the first resistor (Rf); and
- the second parameter set comprises a second saturation current and a second emission coefficient, each associated with the second current source (Ir), and a second resistance of the second resistor (Rr).

**3.** Method according to claim 1 or 2, wherein, for the junction voltage (Vd) being a reverse voltage,

- the first parameter set comprises a first reverse breakdown voltage, a first reverse current at the first reverse breakdown voltage and a first reverse breakdown voltage ideality factor, each associated with the first current source (If); and
- the second parameter set comprises a second reverse breakdown voltage, a second reverse current at the second reverse breakdown voltage and a second reverse breakdown voltage ideality factor, each associated with the second current source (Ir).

**4.** Method according to one of claims 1 to 3, wherein

- the first parameter set comprises a first high-injection knee current and/or a first reverse high-injection knee current, each associated with the first current source (If); and
- the second parameter set comprises a second high-injection knee current and/or a second reverse high-injection knee current, each associated with the second current source (Ir).

**5.** Method according to one of claims 1 to 4, wherein

- the semiconductor junction is further represented by a junction capacitance (Cj) connected in parallel to the first current source (If), a value of the junction capacitance (Cj) being dependent on the first parameter set and the junction voltage (Vd); and
- the junction current is calculated depending on the value of the junction capacitance (Cj).

**6.** Method according to claim 5, wherein the first parameter set comprises a zero-bias junction capacitance, a junction potential, a grading coefficient and a forward-bias depletion capacitance coefficient, each associated with the junction capacitance (Cj).

**7.** Method according to one of claims 1 to 6, wherein the junction current is calculated by summing up the first and the second current.

**8.** Method for determination of parameters of a semiconductor device (Dz), comprising

- providing the semiconductor device (Dz) comprising a semiconductor junction;
- measuring a forward set of current-voltage pairs with the semiconductor device (Dz), wherein a junction voltage (Vd) across the semiconductor junction is a forward voltage;
- measuring a reverse set of current-voltage pairs with the semiconductor device (Dz), wherein the junction voltage (Vd) is a reverse voltage;
- representing the semiconductor junction as a parallel connection of a first and a second series connection (DF, DR), wherein the first series connection (DF) comprises a first current source (If) and a first resistor (Rf) and the second series connection (DR) comprises a second current source (Ir) and a second resistor (Rr) and wherein a first parameter set is associated with the first series connection (DF) and a second parameter set is associated with the second series connection (DR);
- setting first parameters of the second parameter set which are associated with a forward operation of the second current source (Ir);
- determining, from the forward set of current-voltage pairs, first parameters of the first parameter set which are associated with a forward operation of the first current source (If) and with the first resistor (Rf);
- determining, from the reverse set of current-voltage pairs, second parameters of the first parameter set which are associated with a reverse operation of the first current source (If); and
- determining, from the reverse set of current-voltage pairs, second parameters of the second parameter set which are associated with a reverse operation of the second current source (Ir) and with the second resistor (Rr).

**9.** Method according to claim 8, wherein determining of first parameters of the first parameter set comprises determining a first saturation current and a first emission coefficient, each associated with the first current source (If), and determining a first resistance of the first resistor (Rf).

10. Method according to claim 8 or 9, wherein setting of first parameters of the second parameter set comprises setting a second saturation current and a second emission coefficient, each associated with the second current source (Ir).

11. Method according to one of claims 8 to 10, wherein determining of second parameters of the first parameter set comprises determining a first reverse breakdown voltage, a first reverse current at the first reverse breakdown voltage and a first reverse breakdown voltage ideality factor, each associated with the first current source (If).

12. Method according to claim 11, wherein determining of the first reverse breakdown voltage comprises setting the first reverse breakdown voltage to a value being greater than an actual breakdown voltage of the semiconductor device (Dz).

13. Method according to one of claims 8 to 12, wherein determining of second parameters of the second parameter set comprises determining a second reverse breakdown voltage, a second reverse current at the second reverse breakdown voltage and a second reverse breakdown voltage ideality factor, each associated with the second current source (Ir), and determining a second resistance of the second resistor (Rr).

14. Method according to one of claims 8 to 13, wherein

- determining of first parameters of the first parameter set comprises determining a first high-injection knee current associated with the first current source (If); and
- determining of second parameters of the second parameter set comprises determining a second reverse high-injection knee current associated with the second current source (Ir).

Fig 1

Fig 2

# Fig 3

S0 — Start

S1 — Set IS2 and N2 of DR

S2 — Extract IS1, N1, IK1 and
RS1 of DF
from forward set of I-V pairs

S3 — Extract BV1, IBV1 and NZ1
of DF from reverse low
current leakage region of
reverse set of I-V pairs

S4 — Extract BV2, IBV2 and NZ2
of DR from avalanche region
of reverse set of I-V pairs

S5 — Extract IKR2, RS2 of DR
from high current avalanche
region of
reverse set of I-V pairs

SE — End

## Fig 4

FORWARD

## Fig 5

REVERSE

Fig 6

Fig 7

Fig 8

**Europäisches Patentamt**
**European Patent Office**
**Office européen des brevets**

# EUROPEAN SEARCH REPORT

Application Number

EP 08 01 4217

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ADEL S. SEDRA, KENNETH C. SMITH: "Microelectronic Circuits, 5th edition" 2004, OXFORD UNIVERSITY PRESS , NEW YORK, OXFORD , XP002507515 * pages 139-234 * | 1-14 | INV. G06F17/50 |
| A | US 2008/151447 A1 (CZARNECKI STANLEY W [US] ET AL) 26 June 2008 (2008-06-26) | 1-14 | |

TECHNICAL FIELDS SEARCHED (IPC)

G06F

The present search report has been drawn up for all claims

| Place of search | Date of completion of the search | Examiner |
|---|---|---|
| Munich | 11 December 2008 | Anticoli, Claud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

16

## ANNEX TO THE EUROPEAN SEARCH REPORT
## ON EUROPEAN PATENT APPLICATION NO.

EP 08 01 4217

This annex lists the patent family members relating to the patent documents cited in the above-mentioned European search report.
The members are as contained in the European Patent Office EDP file on
The European Patent Office is in no way liable for these particulars which are merely given for the purpose of information.

11-12-2008

| Patent document cited in search report | Publication date | Patent family member(s) | Publication date |
|---|---|---|---|
| US 2008151447 A1 | 26-06-2008 | CN 101207283 A | 25-06-2008 |

For more details about this annex : see Official Journal of the European Patent Office, No. 12/82